Europäisches Patentamt

European Patent Office

Office européen des brevets

(11) Veröffentlichungsnummer: **0 330 896**
**A2**

## (12) EUROPÄISCHE PATENTANMELDUNG

(21) Anmeldenummer: **89102448.1**

(51) Int. Cl.⁴: **H01L 21/603**

(22) Anmeldetag: **13.02.89**

(30) Priorität: **03.03.88 DE 3806980**

(43) Veröffentlichungstag der Anmeldung:
**06.09.89 Patentblatt 89/36**

(84) Benannte Vertragsstaaten:
**CH DE FR GB IT LI SE**

(71) Anmelder: **Siemens Aktiengesellschaft**
**Wittelsbacherplatz 2**
**D-8000 München 2(DE)**

(72) Erfinder: **Schwarzbauer, Herbert, Dr.rer.nat.**
**Kössener Strasse 13 a**
**D-8000 München 70(DE)**

(54) Verfahren zum Befestigen von Halbleiterbauelementen auf Substraten und Anordnungen zur Durchführung desselben.

(57) Zum Befestigen von Halbleiterbauelementen (3), insbesondere Leistungshalbleitern, auf Substraten (1) wird ein Diffusionsschweißverfahren angegeben, bei dem die zu verbindenden Flächen, die mit einer Edelmetall-Kontaktierungsschicht versehen sind, bei gemäßigter Temperatur von etwa 150 bis 250 °C mit mindestens 500 kp/cm² zusammengepreßt werden. Bauelemente (3) mit strukturierter Oberseite können mit Substraten verbunden werden, wenn sie gemeinsam mit einem Körper (17, 18) aus elastisch verformbarem Material, z.B. Silikonkautschuk, in eine durch einen bewegbaren Stempel (21) abgeschlossene, den Anpressdruck übertragende Aufnahmekammer (15a, 15b, 21) eingelegt werden, wobei der deformierbare Körper (17, 18) beim Erreichen des Anpressdrucks den verbleibenden Innenraum der Aufnahmekammer vollständig ausfüllt.

FIG 3

# Verfahren zum Befestigen von Halbleiterbauelementen auf Substraten und Anordnungen zur Durchführung desselben

Die Erfindung bezieht sich auf ein Verfahren zum Befestigen von Halbleiterbauelementen auf Substraten durch Diffusionsschweißen nach dem Oberbegriff des Patentanspruchs 1 oder des Patentanspruchs 2 sowie auf Anordnungen zur Durchführung desselben.

Ein solches Verfahren wird in der DE-OS 33 25 355 beschrieben. Dabei erfolgt die Metallisierung der mit dem Substrat zu verbindenden Fläche des Halbleiterbauelements durch chemisches Abscheiden von Metall oder durch Aufdampfen von Metall im Vakuum. Aus der DE-OS 33 25 355 ist noch ein weiteres Verfahren dieser Art bekannt, bei dem eine Metallfolie zwischen die miteinander zu verbindenden Flächen des Bauelements und des Substrats eingefügt und zusammen mit den zu verbindenden Teilen einem Diffusionsschweißvorgang unterzogen wird. Bei diesem Verfahren ist es jedoch nachteilig, daß das Diffusionsschweißen in einer Vakuumkammer erfolgt und bei einem Anpreßdruck von etwa 150 kp/cm² eine Temperatur von etwa 550° C erfordert. Diese hohe Temperaturbelastung führt durch die unterschiedlichen Wärmeausdehnungskoeffizienten der einzelnen Teile zu hohen Spannungen im Halbleiterbauelement, was sich beim fertigen Produkt durch entsprechende Verwölbungen bemerkbar macht.

Der Erfindung liegt die Aufgabe zugrunde, ein Verfahren der eingangs genannten Art zum Befestigen von Halbleiterbauelementen auf Substraten mittels Diffusionsschweißen anzugeben, das eine wesentlich geringere Wärmebelastung des Bauelements mit sich bringt als das bei den herkömmlichen Verfahren der Fall ist. Das wird erfindungsgemäß durch eine Ausbildung nach dem kennzeichnenden Teil des Patentanspruchs 1 oder des Patentanspruchs 2 erreicht.

Der mit der Erfindung erzielbare Vorteil liegt insbesondere in der relativ geringen Temperaturbelastung von etwa 150 bis 250° C, die mit den im Betrieb von Leistungshalbleitern, insbesondere Leistungsthyristoren, auftretenden Temperaturen vergleichbar ist, so daß das Verfahren auch an fertiggestellten Halbleiterbauelementen durchführbar ist. Weiterhin kann auf eine Vakuumkammer für die Durchführung des Diffusionsschweißvorgangs verzichtet werden.

Die Weiterbildung des Verfahrens nach Patentanspruch 3 zeichnet sich dadurch aus, daß infolge des vorgesehenen Druckübertragungsmediums eine sehr schonende Druckübertragung auf das Halbleiterbauelement erfolgt, so daß dieses auch eine strukturierte Oberseite aufweisen kann, wie sie zum Beispiel beim Aufintegrieren von MOS-Strukturen entsteht, ohne daß solche Strukturen durch den Anpreßdurck beschädigt oder zerstört werden.

Die Patentansprüche 4 bis 12 sind auf Anordnungen zur Durchführung des erfindungsgemäßen Verfahrens gerichtet.

Die Erfindung wird nachfolgend anhand der Zeichnung näher erläutert. Dabei zeigt:

Fig. 1 ein Halbleiterbauelement und ein Substrat im Querschnitt sowie eine zur Durchführung des erfindungsgemäßen Verfahrens geeignete Anordnung,

Fig. 2 ein Halbleiterbauelement und ein Substrat mit einer dazwischengelegten Metallfolie in einer Anordnung nach Fig. 1,

Fig. 3 eine zur Durchführung einer Weiterbildung des erfindungsgemäßen Verfahrens geeignete Anordnung,

Fig. 4 die Anordnung nach Fig. 3 während der Druckübertragung auf die aus Substrat und Halbleiterbauelement bestehende Anordnung und

Fig. 5 eine weitere zur Durchführung der Weiterbildung des erfindungsgemäßen Verfahrens geeignete Anordnung.

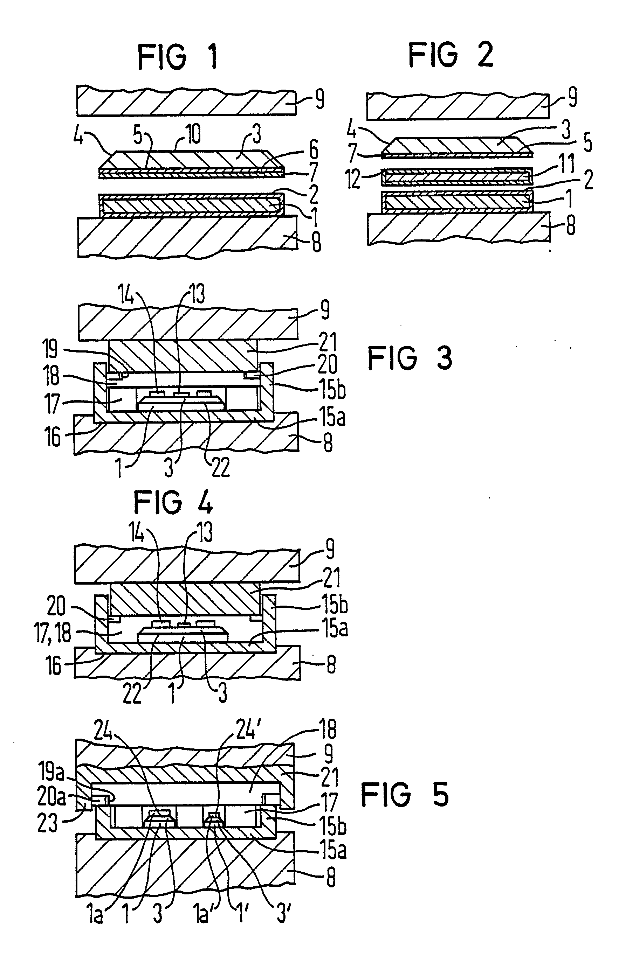

In Fig. 1 ist ein Substrat 1 dargestellt, das nach dem erfindungsgemäßen Verfahren mit einem Halbleiterbauelement durch einen Diffusionsschweißvorgang verbunden werden soll. Beim Substrat 1 handelt es sich zum Beispiel um eine 1,5 mm starke Scheibe aus Molybdän mit einem Durchmesser von etwa 29,6 mm. Diese wird zunächst mit einer chemisch oder galvanisch aufgetragenen oder aufgedampften Edelmetall-Kontaktierungsschicht 2, zum Beispiel einer Gold-oder Silberschicht mit einer Dicke von etwa 1 bis 2 μm, überzogen. Mit 3 ist der Siliziumkörper eines großflächigen Halbleiterbauelements, zum Beispiel eines Leistungsthyristors, bezeichnet, der auf dem Substrat 1 befestigt werden soll. 4 stellt den abgeschrägten Rand von 3 dar. Nach der Verbindung des Thyristors 3 mit dem Substrat 1 bildet das letztere die anodenseitige Elektrode. Die Unterseite 5 des Siliziumkörpers 3 wird mit einer metallischen Zwischenschicht 6, zum Beispiel aus Al, Ag, Cu oder Au, mit einer Schichtdicke von etwa 10 bis 20 μm überzogen. Diese Zwischenschicht 6 ist plastisch verformbar, um im weiteren Verlauf des Verfahrens die Rauhtiefen der miteinander zu verbindenden Flächen, das heißt der Oberseite des Substrats 1 und der Unterseite 5 des Bauelements 3, die etwa einen Bereich von 1 bis 1,5 μm nicht überschreiten sollten, auszugleichen. Auf die metallische Zwischenschicht 6 wird, falls sie nicht aus Edelmetall besteht, eine weitere Edelmetall-Kontaktierungsschicht 7 mit einer Dicke von etwa 1 bis 2 μm aufgebracht, die vorzugsweise aus Au oder Ag besteht.

Die in vorstehender Weise mit den Schichten 2, 6 und 7 versehenen Teile 1 und 3 werden nun so aufeinandergesetzt, daß sich die Schichten 2 und 7 berühren, wobei die Anordnung 1, 3 in eine vorzugsweise hydraulische Presse mit den Pressenstempeln 8 und 9 eingebracht wird. Die Pressenstempel werden beheizt, so daß die Anordnung 1, 3 auf eine Temperatur gebracht wird, die etwa im Bereich von 150 bis 250°C liegt, also in einem gemäßigten Temperaturbereich, der mit der Betriebstemperatur eines großflächigen Leistungshalbleiters, zum Beispiel einer Diode, die 200°C betragen kann, vergleichbar ist. Die Pressenstempel 8 und 9 werden durch Betätigung der Presse so gegeneinander bewegt, daß die Teile 1 und 3 mit einem Anpreßdruck von etwa 500 bis 2500 kp/cm² oder darüber während einiger Minuten zusammengepreßt werden. Mit diesem Diffusionsschweißvorgang wird eine Verbindung des Halbleiterbauelements 3 und des Substrats 1 erreicht, die einen sehr geringen elektrischen und thermischen Übergangswiderstand, einen sehr hohen Homogenitätsgrad und eine große Haftfestigkeit aufweist.

Bei dem vorstehend beschriebenen Diffusionsschweißvorgang nach der Erfindung kann es zweckmäßig sein, die Oberseite 10 des Halbleiterbauelements 3 durch eine plastisch verformbare Metallscheibe, zum Beispiel aus Al, vor Beschädigungen durch den Pressenstempel 9 zu schützen.

In Abweichung von der bisher beschriebenen Ausgestaltung des Verfahrens kann eine plastisch verformbare, metallische Zwischenschicht, die der Schicht 6 entspricht, auf dem Substrat 1 vorgesehen werden. Diese Zwischenschicht weist dann zweckmäßigerweise auch eine Schichtdicke von 10 bis 20 μm auf. Erst auf dieser Zwischenschicht wird dann die Edelmetall-Kontaktierungsschicht 2 aus einem der genannten Metalle mit der beschriebenen Dicke und in der beschriebenen Weise aufgebracht. Hierbei kann die metallische Zwischenschicht 6 entfallen. Wenn sie zusätzlich zu der auf dem Substrat vorgesehenen metallischen Zwischenschicht bestehen bleibt, so gleicht sie zusammen mit dieser die Unebenheiten der beiden miteinander zu verbindenden Flächen des Halbleiterbauelements 3 und des Substrats 1 aus.

Nach einer anderen, bevorzugten Ausbildung des erfindungsgemäßen Verfahrens wird gemäß Fig. 2 eine Folie 11 oder ein dünnes Blech aus einem plastisch deformierbaren Metall, zum Beispiel Al, Ag, Cu oder Au, mit einer Foliendicke von etwa 10 bis 20 μm beim Aufeinandersetzen des Halbleiterbauelements 3 und des Substrats 1 zwischen die zu verbindenden Flächen gelegt. Auch hier werden das Substrat 1 und die Unterseite 5 des Halbleiterbauelements 3 mit Edelmetall-Kontaktierungsschichten 2 und 7 in der beschriebenen Weise überzogen. Die Folie 11 übernimmt hierbei die Funktion der Zwischenschicht 6 oder der bereits erwähnten Zwischenschicht, die der das Substrat 1 abdeckenden Edelmetall-Kontaktierungsschicht 2 unterlegt wird. Andererseits kann die Metallfolie 11 auch zusätzlich zu einer oder zu beiden Zwischenschichten, die den Kontaktierungsschichten 2 oder 7 unterlegt sind, vorgesehen sein. Wenn die Metallfolie 11 nicht ganz aus Edelmetall besteht, so müssen wenigstens ihre beiden den Schichten 2 und 7 anliegenden Oberflächen aus einem Edelmetall, zum Beispiel Ag oder Au, gebildet sein. In Fig. 2 ist ein solcher Edelmetallüberzug 12 dargestellt, der auf einer aus Al oder Cu bestehenden Metallfolie 11 vorgesehen ist. Nach dem Zusammenlegen der Teile 1 und 3 unter Zwischenfügung der Metallfolie 11 wird der bereits oben beschriebene Diffusionsschweißvorgang auch bei dieser Ausbildung des erfindungsgemäßen Verfahrens durchgeführt.

Nach einer bevorzugten Weiterbildung des erfindungsgemäßen Verfahrens können Bauelemente 3 mit einer strukturierten oder unebenen Oberseite auf einem Substrat durch Diffusionsschweißen befestigt werden, ohne daß mechanische Beschädigungen des Bauelements oder seiner Oberseite hervorgerufen werden. Hierzu sei auf Fig. 3 verwiesen, in der ein Thyristor dargestellt ist, dessen Halbleiterkörper 3 auf seiner Oberseite mit einer zum Zünden und gegebenenfalls zum Löschen des Thyristors dienenden Elektrode 13 sowie mit einer kathodenseitigen Elektrode 14 versehen ist. Fig. 3 zeigt auch eine zweckmäßige Anordnung zur Durchführung des insoweit weitergebildeten Verfahrens nach der Erfindung.

Nach dem Überziehen der Teile 1 und 3 mit den Kontaktierungsschichten 2 und 7, wobei wenigstens eine derselben mit einer plastisch deformierbaren metallischen Zwischenschicht, zum Beispiel 6, unterlegt wird und /oder gegebenenfalls eine plastisch deformierbare Metallfolie 11 zwischen den Teilen 1 und 3 vorgesehen wird, geht man dabei wie folgt vor:

Die aus den aufeinandergesetzten Teilen 1 und 3 gebildete Anordnung wird in eine metallische, topfförmige Aufnahmevorrichtung 15a, 15b eingelegt, die aus einem Bodenteil 15a und einem seitlichen Wandungsteil 15b besteht und in einer Ausnehmung 16 eines Pressenstempels 8 gelagert ist. Ein z.B. als Kreisring geformtes Teil 17 aus temperaturbeständigem, elastisch verformbarem Material, z.B. aus Silikonkautschuk oder aus einem anderen temperaturbeständigen, insbesondere fluorierten Elastomer, wird in die Aufnahmevorrichtung 15a, 15b mit eingelegt, so daß es die Anordnung 1, 3 gemäß Fig. 3 umgibt und vorzugsweise auch zentriert.

Ein weiteres, als Scheibe geformtes Teil 18 aus dem gleichen Material wie das Teil 17 oder aus einem anderen elastisch verformbaren Material wird sodann in den Innenraum der Aufnahmevorrichtung 15a, 15b so eingefügt, daß es diesen nach oben abschließt. Dabei kann sich das Teil 18 auf der Oberseite des Teils 17 abstützen. In eine ringförmige Ausnehmung 19 des Teils 18 wird ein Dichtungsring 20, z.B. aus Metall, Keramik oder Kunststoff, eingelegt, der der Innenseite des seitlichen Wandungsteils 15b eng anliegt. Sodann wird die Aufnahmevorrichtung 15a, 15b durch Auflegen eines metallischen Stempels 21 auf den Dichtungsring 20 oder die Oberfläche des Teils 18 zu einer geschlossenen Aufnahmekammer ergänzt. Der Stempel 21 ist dabei in Richtung des Bodenteils 15a bewegbar gelagert. Er stützt sich gegen den Pressenstempel 9 ab.

Der Pressenstempel 8 wird beheizt, so daß die Anordnung 1, 3 auf die gewünschte Temperatur erhitzt wird, die etwa im Bereich von 150° bis 250°C liegt. Die Pressenstempel 8 und 9 werden durch Betätigung der Presse gegeneinander bewegt, so daß der Stempel 21 tiefer in den Innenraum der Aufnahmevorrichtung 15a, l5b eindringt, wobei sich die Teile 17 und 18 elastisch deformieren. Fig. 4 zeigt die Stellung der Pressenstempel 8 und 9, in der auf die Teile 1 und 3 ein für das Diffusionsschweißen erforderlicher Druck von mindestens 500 kp/cm² unter Aufrechterhaltung der genannten Temperatur während einiger Minuten ausgeübt wird. Dabei ist das Volumen der Teile 17 und 18 so bemessen, daß sie den vom Bauelement 3 und vom Substrat 1 nicht eingenommenen Innenraum der Aufnahmekammer 15a, 15b, 21 unter Vermeidung eines direkten Kontaktes zwischen dem Stempel 21 und dem Bauelement 3 vollständig ausfüllen. Auf diese Weise gelingt es, trotz der durch die unterschiedliche Höhe der Elektroden 13 und 14 und durch die Abschrägung 4 gegebenen Strukturierung der Bauelementoberseite die Teile 1 und 3 über der gesamten Fläche 22, in der sie aufeinanderstoßen, mit konstantem Druck aufeinanderzupressen, so daß eine völlig gleichmäßige Verbindung der Teile erfolgt. Die elastische Deformation der Teile 17 und 18 ist dabei so groß, daß die Druckübertragung auf die Bauelementoberseite völlig gleichmäßig ist, ohne daß jedoch Teile des elastisch verformbaren Materials in den zwischen den Teilen 1 und 3 bestehenden Spalt eindringen. Damit wird eine einwandfreie Verbindung der Teile 1 und 3 auch im unmittelbaren Randbereich dieses Spalts erreicht. Das Austreten von Teilen des elastisch verformbaren Materials zwischen dem seitlichen Wandungsteil 15b und dem Stempel 21 wird zweckmäßigerweise durch den Dichtungsring 20 verhindert. Das vorstehend beschriebene Verhalten der elastisch deformierbaren Teile 17 und 18 kann als "quasi-hydrostatisch" bezeichnet werden.

Eine gute Verbindung der Teile 1 und 3 durch Diffusionsschweißen wird dadurch erreicht, daß auf die Anordnung 1, 3 ein Druck von mindestens 500 kp/cm² bei einer Temperatur von z.B. 230°C während einer Zeitdauer von etwa 10 Minuten ausgeübt wird. Es ist jedoch darauf hinzuweisen, daß bereits bei Diffusionszeiten von einigen Sekunden ausreichende Ergebnisse erzielt werden und daß der Druck auch auf 1 bis 2 t/cm² oder darüber gesteigert werden kann. Die Temperaturen können in einem Bereich liegen, der einen unteren Grenzwert von etwa 150°C und einen oberen Grenzwert von etwa 250°C aufweist. Weiterhin ist hervorzuheben, daß das Diffusionsschweißen in normaler Atmosphäre vorgenommen wird, d.h. eine Anwendung von Schutzgas nicht erforderlich ist.

Nach dem Diffusionsschweißen wird die Anordnung 1, 3 aus der Aufnahmekammer 15a, 15b, 21 entfernt, wobei die Teile 17 und 18 wieder ihre ursprüngliche, in Figur 3 dargestellte Form annehmen. Sie stehen dann für das Diffusionsschweißen von zahlreichen weiteren Bauelement-Substrat-Anordnungen zur Verfügung. Anstelle der bisher beschriebenen Teile 17 und 18, die kreisring- und plattenförmig ausgebildet sind, kann im Rahmen der Erfindung auch ein einziges Teil aus dem gleichen Material verwendet werden, sofern dessen Volumen dem der beiden Teile 17 und 18 entspricht.

Fig. 5 zeigt eine Variante der Anordnung nach den Figuren 3 und 4, bei der der in Richtung des Bodenteils 15a bewegbare Stempel 21 einen vorgezogenen Rand 23 aufweist, der das seitliche Wandungsteil 15b der Aufnahmevorrichtung umgreift. Fig. 5 zeigt entsprechend Fig. 3 jene Stellung der Pressenstempel 8 und 9, bei der noch kein Anpreßdruck auf zwei in die Aufnahmevorrichtung 15a, 15b eingelegte Anordnungen 1, 3 und 1', 3' ausgeübt wird. Mit 1' ist dabei ein weiteres Substrat bezeichnet, mit 3' ein weiteres Halbleiterbauelement. Von Fig. 1 unterscheiden sich die Anordnungen 1, 3 und 1', 3' beispielsweise aber nicht zwangsläufig dadurch, daß die Bauelemente 3 und 3' jeweils mit einem weiteren Substrat 1a bzw. 1a' verbunden werden, und zwar im Bereich ihrer oberen Grenzflächen. Die Verbindungen mit den Substraten 1a und 1a' erfolgen ebenfalls durch Diffusionsschweißen, wobei die die Spalte 24, 24' begrenzenden Flächen der Substrate und der Halbleiterbauelemente wieder mit Edelmetall- Kontaktierungsschichten überzogen sind. Durch die Elastizität der Teile 17 und 18, die in Fig. 5 im nicht deformierten Zustand dargestellt sind, ist es möglich, auch solche Anordnungen 1, 3 und 1', 3' in einem Preßvorgang zu verbinden, deren Bauelementabmessungen, insbesondere Bauelementhöhen, unterschiedlich sind. Bei der Anordnung nach Fig. 5 ist es zweckmäßig, das als Platte ausgebildete Teil 18 in den durch den vorstehenden Rand 23 gebildeten Innenraum des bewegbaren Stempels 21 einzulegen und durch den Dichtungsring 20a, der in einer Ausnehmung 19a liegt, in seiner Lage zu halten. Das Teil 17 ist hier zweckmäßigerweise als eine kreisförmige Scheibe ausgebildet, die mit Ausnehmungen für die Anordnungen 1, 3 und 1', 3' versehen ist. Mit Vorteil ist die Anordnung nach Fig. 5 so ausgebildet, daß der in Richtung des Bodenteils 15a bewegbare Stempel 21 aus einem Teil des Pressenstempels 9 besteht.

Der beschriebene Diffusionsschweißvorgang geht als Festkörperreaktion ohne das Auftreten flüssiger Phasen vor sich. Dabei eignet sich das beschriebene Verfahren insbesondere zum Befestigen von großflächigen, in MOS-Technologie hergestellten oder mit MOS-Strukturen versehenen Leistungshalbleitern auf Substraten.

**Ansprüche**

1. Verfahren zum Befestigen von Halbleiterbauelementen, insbesondere großflächigen Leistungshalbleitern, auf Substraten durch Diffusionsschweißen, bei dem die mit dem Substrat (1) zu verbindende Fläche des Halbleiterbauelements (3) mit einer Metallisierung versehen wird und bei dem das Halbleiterbauelement (3) auf das Substrat (1) aufgesetzt und unter Erhitzen mit diesem zusammengepreßt wird, **dadurch gekennzeichnet, daß** als Metallisierung eine erste Edelmetall-Kontaktierungsschicht (7) verwendet wird, daß die mit dem Halbleiterbauelement (3) zu. verbindende Fläche des Substrats (1) mit einer zweiten Edelmetall-Kontaktierungsschicht (2) versehen wird, daß das Halbleiterbauelement (3) und das Substrat (1) auf Temperaturen erhitzt werden, die etwa im Bereich von 150 bis 250°C liegen, und daß das Zusammenpressen der Teile (1, 3) im lufterfüllten Raum mit einem Anpreßdruck erfolgt, der etwa in einem Bereich von 500 bis 2500 kp/cm² liegt.

2. Verfahren zum Befestigen von Halbleiterbauelementen, insbesondere großflächigen Leistungshalbleitern, auf Substraten durch Diffusionsschweißen, bei dem die mit dem Substrat (1) zu verbindende Fläche des Halbleiterbauelements (3) mit einer Metallisierung versehen wird und bei dem das Halbleiterbauelement (3) auf das Substrat (1) aufgesetzt und unter Erhitzen mit diesem zusammengepreßt wird, **dadurch gekennzeichnet, daß** als Metallisierung eine erste Edelmetall-Kontaktierungsschicht (7) verwendet wird, daß die mit dem Halbleiterbauelement (3) zu verbindende Fläche des Substrats (1) mit einer zweiten Edelmetall-Kontaktierungsschicht (2) versehen wird, daß zwischen die beiden Edelmetall-Kontaktierungsschichten (2, 7) eine plastisch deformierbare Metallfolie (11) eingelegt wird, die zumindest an ihren beiden den Edelmetall-Kontaktierungsschichten (2, 7) anliegenden Oberflächen aus einem Edelmetall besteht, daß das Halbleiterbauelement (3), das Substrat (1) und die Metallfolie (11) auf Temperaturen erhitzt werden, die etwa im Bereich von 150 bis 250°C liegen, und daß das Zusammenpressen dieser Teile (1, 3, 11) im lufterfüllten Raum mit einem Anpreßdruck erfolgt, der etwa in einem Bereich von 500 bis 2500 kp/cm² liegt.

3. Verfahren nach Anspruch 1 oder 2, **dadurch gekennzeichnet, daß** das gegebenenfalls unter Zwischenfügung der Metallfolie (11) auf das Substrat (1) aufgesetzte Bauelement (3) in eine Aufnahmevorrichtung (15a, 15b) eingelegt wird, die aus einem Bodenteil (15a) und einem seitlichen Wandungsteil (15b) besteht und durch einen in Richtung des Bodenteils (15a) bewegbaren Stempel (21) zu einer geschlossenen Aufnahmekammer ergänzt wird, wobei sich das Bodenteil (15a) gegen einen ersten Pressenstempel (8) und der in Richtung des Bodenteils bewegbare Stempel (21) gegen einen zweiten Pressenstempel (9) abstützen, daß ein deformierbarer Körper (17, 18) aus temperaturbeständigem, elastisch verformbaren Material in die Aufnahmevorrichtung (15a, 15b) mit eingelegt wird und daß das Volumen des deformierbaren Körpers (17, 18) so bemessen wird, daß er den vom Bauelement (3) und vom Substrat (1) nicht eingenommenen Innenraum der Aufnahmekammer (15a, 15b, 21) beim Erreichen des genannten Anpreßdrucks unter Vermeidung eines direkten Kontaktes zwischen dem Stempel (21) und dem Bauelement (3) bzw. dem Substrat (1) vollständig ausfüllt.

4. Anordnung zur Durchführung des Verfahrens nach Anspruch 3, **dadurch gekennzeichnet, daß** eine Aufnahmevorrichtung vorgesehen ist, in die das auf das Substrat (1) aufgesetzte Bauelement (3) und der deformierbare Körper (17, 18) einlegbar sind, daß die Aufnahmevorrichtung aus einem Bodenteil (15a) und einem seitlichen Wandungsteil (15b) besteht und durch einen in Richtung des Bodenteils bewegbaren Stempel (21) zu einer geschlossenen Aufnahmekammer ergänzt wird und daß die Aufnahmekammer (15a, 15b, 21) in eine den Anpreßdruck aufbringende Presse eingebracht wird, wobei sich das Bodenteil (15a) gegen einen ersten Pressenstempel (8) und der in Richtung des Bodenteils bewegbare Stempel (21) gegen einen zweiten Pressenstempel (9) abstützen.

5. Anordnung nach Anspruch 4, **dadurch gekenn zeichnet, daß** der in Richtung des Bodenteils bewegbare Stempel (21) vom seitlichen Wandungsteil (15b) der Aufnahmevorrichtung umschlossen wird und daß ein an der Innenseite des seitlichen Wandungsteils (15b) anliegender Dichtungsring (20) vorgesehen ist, der sich gegen den Rand des Stempels (21) abstützt.

6. Anordnung nach Anspruch 4, **dadurch gekennzeichnet,** daß der in Richtung des Bodenteils bewegbare Stempel (21) einen vorgezogenen Rand (23) aufweist, der das seitliche Wandungsteil (15b) der Aufnahmevorrichtung umgreift, und daß ein der Innenseite des vorgezogenen Randes (23) anliegender Dichtungsring (20a) vorgesehen ist, der sich gegen den Rand des seitlichen Wandungsteils (15b) der Aufnahmevorrichtung abstützt.

7. Anordnung nach Anspruch 4, **dadurch gekennzeichnet,** daß der deformierbare Körper (17, 18) zweiteilig ausgebildet ist, wobei das erste Teil (17) ringförmig ist und derart in die Aufnahmevorrichtung (15a, 15b, 21) eingelegt wird, daß es das Bauelement (3) umgibt, und das zweite Teil aus einer in den Innenraum der Aufnahmevorrichtung oberhalb des Halbleiterbauelements (3) einlegbaren Platte (18) besteht.

8. Anordnung nach Anspruch 6, **dadurch gekennzeichnet,** daß der deformierbare Körper (17, 18) zweiteilig ausgebildet ist, wobei das erste Teil (17) ringförmig ist und derart in die Aufnahmevorrichtung (15a, 15b, 21) eingelegt wird, daß es das Bauelement (3) umgibt, und das zweite Teil aus einer Platte (18) besteht, die in dem durch den vorstehenden Rand (23) gebildeten Inneraum des in Richtung des Bodenteils bewegbaren Stempels (21) angeordnet ist.

9. Anordnung nach einem der Ansprüche 4 bis 8, **dadurch gekennzeichnet,** daß der Pressenstempel (8), gegen den sich das Bodenteil (15a) abstützt, zur Erzeugung der genannten Temperaturen beheizbar ist.

10. Anordnung nach einem der Ansprüche 4 bis 9, **dadurch gekennzeichnet,** daß der in Richtung des Bodenteils bewegbare Stempel (21) aus einem Teil des zweiten Pressenstempels (9) besteht.

11. Anordnung nach einem der Ansprüche 4 bis 10, **dadurch gekennzeichnet,** daß der deformierbare Körper (17, 18) aus Silikonkautschuk besteht.

12. Anordnung nach einem der Ansprüche 4 bis 10, **dadurch gekennzeichnet,** daß der deformierbare Körper (17, 18) aus einem temperaturbeständigen Elastomer besteht.

# FIG 1

9

4 5 10 3

6

7

2

1

8

# FIG 2

9

4 3

7 5

12 11

2

1

8

# FIG 3

14 13

9

19 21

18 20

17 15b

16 15a

8

1 3 22

# FIG 4

14 13

9

21

20 15b

17,18 15a

16

8

22 1 3

# FIG 5

24 24' 18

9

19a 21

20a 17

23 15b

15a

8

1a 1 3 1a'' 1' 3'